# EUROPEAN PATENT APPLICATION

(11) **EP 1 524 884 A1**
(43) Date of publication of application: **20.04.2005**
(21) Application number: 03425674.3
(22) Date of filing: 17.10.2003
(51) Int. Cl.: H05B 33/28, H01L 51/30, H01L 51/20

(54) **An electroactive device based on organic compounds, comprising a float-glass substrate**

(71) Applicant: INFM Instituto Nazionale Per La Fisica Della Materia, 16152 Genova (IT); Vitrum- Lux S.A, 4801 Rodange (LU)
(72) Inventor: Blyth, Robert Ian Renton, I-73100 Lecce (IT); Thompson, Julie, I-73100 Lecce (IT); Perrone, Elisabetta, I-73015 Salice Salentino (IT); Carallo, Sonia, I-73040 Aradeo (IT); Maiorano, Vincenzo, I-73013 Galatina (IT); Cingolani, Roberto, I-73100 Lecce (IT); Croce, Angelo, L-4762 Petange (LU); Daneu, Alessandro, I-20149 Milano (IT)
(74) Representative: Rambelli, Paolo

(57) **Abstract**

An electroactive photonic device (D) comprises a substrate (1), at least one cathode layer (2), at least one anode layer (4), and at least one layer of active material (3) based on organic compounds and interposed at least partially between the anode and cathode layers (2, 4). The layers (2, 3, 4) are arranged on the substrate (1) in a predetermined configuration such that the device (D) can convert luminous energy into electrical energy or *vice versa.* The substrate (1) is made of float glass.

## Description

The present invention relates to an electroactive photonic device which uses organic compounds to produce an active layer so that the device can emit light, for example, like a light-emitting diode, or can absorb light, for example, like a solar cell.

Electroactive components which use organic compounds as active material constitute a potentially economical way of producing photonic devices such as light-emitting diodes (or LEDs) and solar cells. These components have the advantage over conventional inorganic semiconductors that they use relatively inexpensive starting materials, that they are easy and inexpensive to manufacture, and that they can be produced on relatively extensive areas. If, as is often the case, the organic materials are soluble, it is possible to use wet processing techniques, for example, such as spin-coating or printing for the deposition, which further simplifies manufacture and reduces production costs.

A photonic device which can emit light or absorb light in its active materials naturally needs a transparent substrate. The substrate also has to house one of the contact electrodes for the device. The deposition of metallic layers on transparent materials in order to produce these contact electrodes, however, is difficult since, in order to achieve a high degree of light transmission, it is necessary to deposit a very thin metal film having a thickness of the order of a few nanometres. A film of this thickness frequently has discontinuities which prevent the conduction of current. This is due particularly to the roughness of the supporting substrate material, which is typically glass, since a material with a roughness of the order of or greater than the maximum thickness permitted for the transparent metal film naturally does not permit the formation of a continuous layer.

The solution which is generally employed therefore provides for the use of a layer of intrinsically transparent conductive material such as indium oxide doped with tin, known as ITO (indium-tin-oxide; see, for example, the documents W.R. Salaneck, S. Stafstrom and J.-L. Bredas, *Conjugated polymer surfaces and interfaces* (Cambridge University Press, 1996); H. Ishii, K. Sugiyama, E. Ito and Y. Hu, Adv. Mater 11, 605 (1999); K. Seki and H. Ishii, J. Electr. Spect. Relat. Phenom. 88, 821 (1998); I.G. Hill, A. Rajagopal, A. Kahn and Y. Hu, Appl. Phys. Lett. 73, 662 (1998); G. Koller, R.I.R. Blyth, S.A. Sardar, F.P. Netzer and M.G. Ramsey, Appl. Phys. Lett. 76, 927 (2000); R.I.R. Blyth, R. Duschek, G. Koller, F.P. Netzer and M.G. Ramsey, J. Appl. Phys. 90, 270 (2001)). This material has to be deposited by sputtering which leads to the production of a film which is conductive and transparent but which is intrinsically very rough on a nanometric scale; for commercially available ITO, roughnesses of 10-20 nanometres are typical (J. Lukkari, M. Alanko, L. Heikkila, R. Laiho and J. Kankare, Chem. Mater. 5, 289 (1993)). This roughness in turn leads to problems in the wet processing of the organic layers. According to these techniques, a material should diffuse from its deposition points in order to fill the areas that remain exposed after direct contact with the printing means so as to form a continuous and even layer, both when the deposition is performed by spin-coating and the diffusion is therefore macroscopic, and when the deposition is performed by printing and the diffusion is microscopic. The roughness of the substrate consequently causes shadow effects which lead to a non-uniform or even discontinuous coating. This creates weak points in the structure of the device which are more frequent the more extensive is the area occupied by the device.

The document WO 00/69625 provides for the use of conductive nitrides for the electrode layer to be deposited on the glass substrate, as an alternative to ITO. However, the transparency of the conductive nitride layer depends on the thickness of the layer.

The object of the present invention is to provide an electroactive photonic device based on organic compounds which does not have the above-mentioned problems and which can therefore be produced on extensive areas with greater reliability.

This object is achieved by an electroactive photonic device having the characteristics defined in Claim 1.

Preferred embodiments of the invention are defined in the dependent claims.

The production of an electroactive organic device on a float-glass substrate in accordance with the invention permits the deposition of an ultra-thin metal coating so that a substrate that is transparent, conductive and substantially smooth can be obtained. This permits the production of devices which, for a given surface extent, have fewer problems of reliability than the prior art.

The inventors have in fact discovered that glass of the type known as float glass has a surface roughness one order of magnitude less than that of the glass that is conventionally used as the substrate, which permits the deposition of ultra-thin metal layers which, in spite of their low thickness, are still able to conduct current.

A further subject of the invention is a light-emitting system, in particular for illumination or indication, characterized in that it comprises a plurality of light-emitting devices according to the invention, arranged in a predetermined configuration.

Preferred but non-limiting embodiments of the invention will now be described with reference to the appended drawings, in which:
Figure 1 is a plan view of an embodiment of the device according to the invention,
Figure 2 is a schematic, perspective view of a portion of the device of Figure 1, and
Figures 3 and 4 are graphs which represent the current-voltage and luminance-voltage characteristics and the electroluminescence spectrum of the device of Figure 1, produced for a light-emission application.

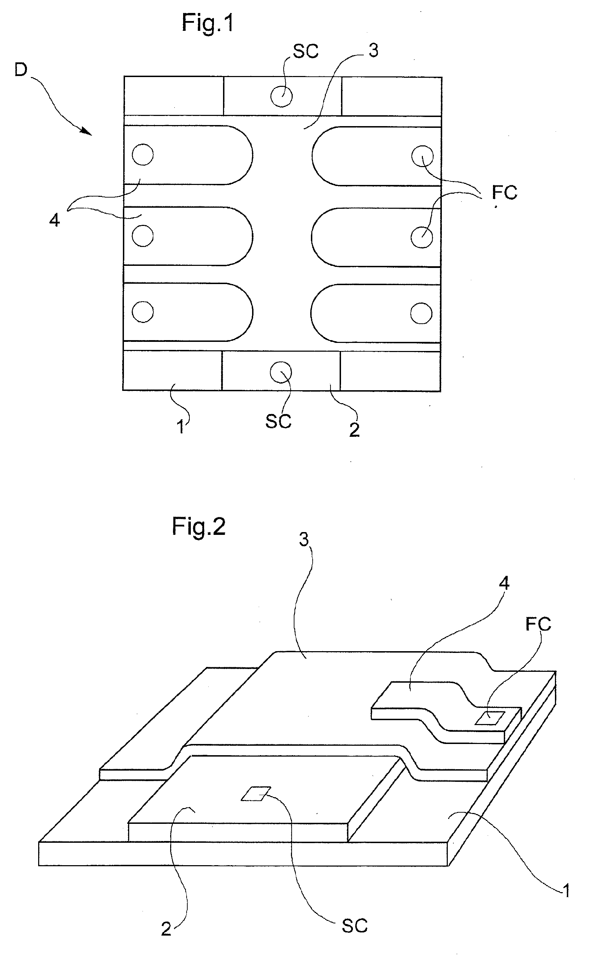

With reference to Figures 1 and 2, these show an electroactive photonic device according to the invention. The device D comprises substantially a float-glass substrate 1 on which a transparent electrode layer 2 is deposited so as to cover the substrate 1 only partially. A layer 3 of organic compounds is deposited on the substrate 1 and on the transparent electrode layer 2 so as simultaneously to cover part of the substrate 1 and part of the transparent electrode layer 2. A second electrode layer 4 is deposited on the layer 3 of organic compounds. This configuration constitutes merely a simple embodiment for the production of an electroactive photonic device but all of the known configurations for the production of such a device are possible, according to the required applications.

As mentioned above, the substrate 1 is made of float glass. As is known, float glass is glass which is produced in sheets by a process known as the float or Pilkington process, which enables a particularly flat and smooth type of glass to be produced. In this process, the raw materials (for example, silica sand, calcium, oxide, soda, and magnesium) are weighed and mixed in the quantities required by the particular applications of use and are then introduced into a furnace where they are fused at high temperature, for example, at 1500°C. The molten glass then flows through a continuous channel from the glass furnace into a bath of molten tin. The glass, which is highly viscous and the tin, which is very fluid, do not mix and the contact surface between the two materials remains particularly flat. When the glass leaves the bath of molten tin, it is cooled sufficiently to pass into a cooling chamber in which it is then cooled at controlled temperature to reach substantially ambient temperature.

According to a variant of the invention, the float glass of the substrate layer 1 may be of the tempered type, that is, glass which has been subjected to a thermal or analogous chemical strengthening treatment of conventional type. Tempered glass is two or more times stronger than the corresponding type of non-treated glass. When it is broken it breaks up into many small fragments which prevent greater damage. This type of glass is normally used for glass facades, sliding doors, entrances to buildings, bath and shower cubicles, and other uses which require better strength and safety properties.

Tempered glass is conventionally produced by two different methods. The first method, which is known as hot treatment, provides for the starting glass sheet to be subjected to heating, for example, to about 680°C, and then to be cooled. If it is cooled rapidly, the tempered glass is up to four times stronger than non-tempered glass and, if it is broken, breaks up into many small fragments. If it is cooled slowly, the glass thus obtained is twice as strong as non-tempered glass, and the fragments of the broken glass appear linear and tend more often to remain in the frame. The second method, which is known as chemical strengthening, provides for the starting glass to be covered with a chemical solution which produces a greater mechanical strength. Chemically strengthened glass has properties similar to those of thermally treated glass.

The transparent electrode 2 is formed by a conductive material, for example, by a thin layer of metal, for example, gold. The active layer 3 is formed by a combination of one or more organic materials which have the necessary light emission or absorption properties. Suitable materials comprise, for example, for emitting green light, poly[(9,9-dioctylfluorenyl-2,7-diyl)-co-(1,4-diphenylene-vinylene-2-methoxy-5-(2-ethylhexyloxy)-benzene)], or PDDMB; for emitting white light, a ternary mixture of poly(9-vinylcarbazole), or PVK, iridium (III) bis(2-(4,6-difluorophenyl)pyridinate-N,C²') picolinate, or FIrpic, and iridium (III) bis(2-(2'benzothienyl)pyridinate-N,C³') (acetylacetonate), or (btp)₂Ir(acac); and for the absorption of visible light, a binary mixture of PVK and of zinc tetra-phenyl-porphyrin, or ZnTPP. The active layer 3 is formed in conventional manner, for example, by spin-coating with a solution of the materials, by evaporation, or by printing with the use of a serigraphic printing process. The second electrode 4 is formed by any conductive material such as aluminium, and may be transparent or opaque according to the intended use of the device. The first electrode 2 or the second electrode 4 may be used as the cathode, according to the required configuration. A preferred embodiment provides for the production of a hole-transport layer (not shown), for example, of poly-(3,4-ethylendioxythiophene) doped with poly(4-styrensulphonate), or PEDOT-PSS, between the anode layer and the layer of active material, and/or of a layer of electron-transport material, for example, of aluminium tris-8-hydroxyquinoline (AlQ₃) between the cathode layer and the active layer.

The process for the production of an experimental example of the device according to the configuration of Figure 1 which is suitable for light-emission applications, will now be described. In this experimental example, the substrate 1 was a piece of float glass with dimensions of 4 x 4 x 0.4 cm, washed with the use of organic solvents (acetone, 2-propanol) and dried in a stream of nitrogen. To produce one of the electrodes, a mask was used to cover the substrate, exposing only the central third of its area. An electrode layer 2 of gold 5 nm thick was then deposited on the masked substrate 1 by evaporation under vacuum (at about 10⁻⁶ mbar) so as to form a central gold strip flanked by bare glass, as can be seen in Figure 2. A hole-transport layer of PEDOT-PSS (not shown) was then deposited by spin-coating on the glass/gold sample, with the use of a rate of rotation of 4000 revolutions/min. The PEDOT-PSS layer was then dried by heating the substrate to 150°C in air for about 20 min. A solution of PVK, FIrpic and (btp)₂Ir(acac), with a predetermined weight ratio was prepared in dichloromethane, with a predetermined concentration. The solution was deposited on the dried PEDOT-PSS layer by spin-coating with a rate of rotation of 2000 revolutions/min, so as to produce the active layer 3. The sample was then transferred into a vacuum chamber for the deposition by evaporation of an electron-transport layer (not shown) of AlQ₃, with a vacuum of about 10⁻⁶ mbar. A mask with from 6 to 8 holes with dimensions of 2 x 4 mm was then placed on the sample. A second, aluminium electrode layer 4 (at least 80 nm thick) was then deposited by evaporation. The mask served to form from six to eight electrodes, each superimposed (through the intermediate layers) both on a portion of the gold layer and on a portion of the glass layer, as shown in Figure 2. It was thus possible to produce a first contact (indicated FC) in the portion of the electrode layer 4 that was not superimposed on the gold, reducing the risk of the formation of direct short-circuits during the making of the contacts. A second contact (indicated SC) was formed on the surface of the gold layer 2 with the use of silver paste.

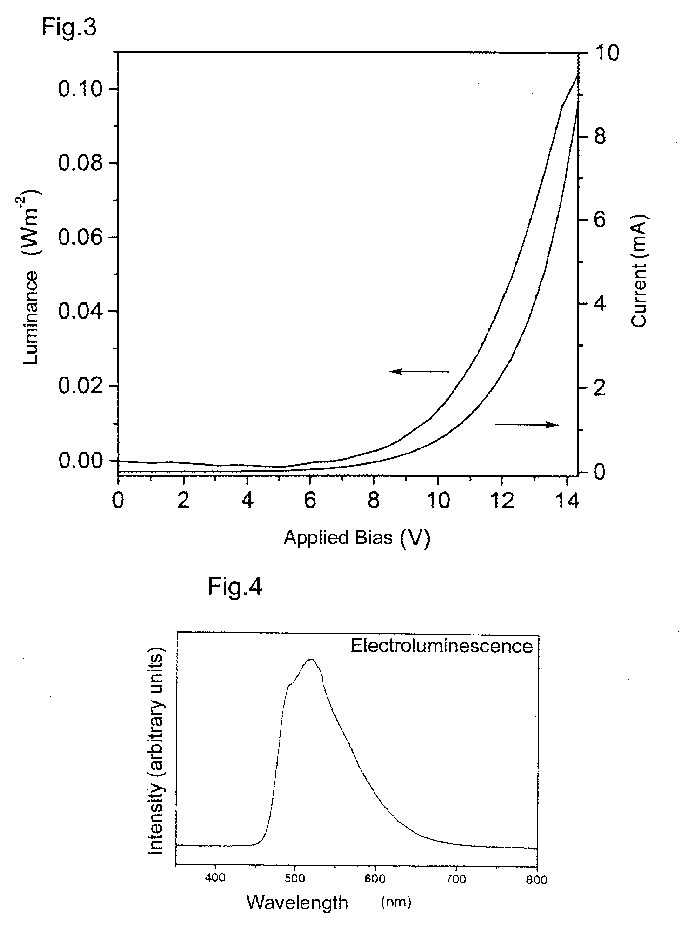

Figures 3 and 4 show the current-voltage and luminance-voltage characteristics and the electroluminescence spectrum of the device thus produced, respectively. The gold electrode layer was used as the anode and the aluminium layer as the cathode.

The process for the production of an experimental example of the device according to the configuration of Figure 1 which is suitable for light absorption applications will now be described. In this experimental example, the substrate was a piece of float glass with dimensions of 4 x 4 x 0.4 cm, washed with the use of organic solvents (acetone, 2-propanol) and dried in a stream of nitrogen. To produce one of the electrodes, a mask was used to cover the substrate, exposing only the central third of its area. An electrode layer 2 of gold 5 nm thick was then deposited on the masked substrate under a vacuum of about 10⁻⁶ mbar so as to form a central gold strip flanked by bare glass, as can be seen in Figure 2. A hole-transport layer of PEDOT-PSS (not shown) was then deposited on the gold/glass sample by spin-coating with the use of a rate of rotation of 4000 revolutions/min. The PEDOT-PSS layer was then dried by heating the substrate to 150°C in air for about 20 min. A solution of PVK and ZnTPP in dichloromethane, with a predetermined weight ratio, at a predetermined concentration, was deposited on the dried PEDOT-PSS layer by spin-coating with a rate of rotation of 2000 revolutions/min, so as to produce the active layer 3. The sample was then transferred to a vacuum chamber for the deposition by evaporation of an electron-transport layer (not shown) of AlQ₃ with a vacuum of about 10⁻⁶ mbar. A mask with from six to eight holes with dimensions of 2 x 4 mm was then placed on the sample. An aluminium electrode layer 4 (at least 80 nm thick) was then deposited by evaporation. The mask served to ensure that from six to eight electrodes were formed, each superimposed (through the intermediate layers) both on a portion of the gold layer and on a portion of the glass layer, as shown in Figure 2. It was thus possible to produce a first contact FC in the portion of the electrode layer 4 which was not superimposed on the gold, reducing the risk of direct short-circuits during the closure of the contacts. A second contact SC was formed on the surface of the gold layer 2 with the use of silver paste.

In general, in order to render the device according to the invention more stable and durable, a coating may be deposited on at least part of the device so as to protect it from attack by atmospheric agents. This can be achieved, for example, by applying a layer of transparent and air-impermeable epoxy resin after the deposition of the final metal contact, by a wet process, by printing or spraying. This is a standard solution for the encapsulation of organic and inorganic LEDs. Alternatively, the coating may be applied by *in situ* evaporation of a transparent, air-impermeable material. With this technique, an additional evaporated layer is deposited after the evaporation of the final contact without removing the finished product from the vacuum system. This avoids exposure of the finished product to air. Suitable materials for *in situ* evaporation are nonconductive evaporable polymers such as PVK. If it suffices for the light emitted or absorbed to be able to pass solely through the glass substrate, the encapsulation layer may even be of non-transparent material.

With the use of a float-glass substrate, it is possible to produce devices on a scale of metres (normally, the dimensions of standard float glass sheets are 6 x 3 m) whereas, with glasses coated with ITO it is not possible to achieve these dimensions. Moreover, the production of a device on a float-glass substrate leads to significantly lower costs than ITO-coated glasses since the deposition of ITO requires dedicated tooling which is not necessary in the device according to the invention.

These characteristics render the invention suitable for many applications, for example, in the field of solar cells or for illumination in the architectural or furnishing fields. In particular, the invention may be used in lamps and light fittings, luminous panels for furniture, indicator devices for interiors and road indicating devices, advertizing boards, and the like. Moreover, the invention can be used in vehicle projectors and indicating devices or for applications in which LEDs are normally used, such as in television monitors and screens, or in maxi-screens for public use. In applications in which safety requirements are important, the variant of the present invention which provides for a layer of tempered float glass can advantageously be used.

Naturally, the principle of the invention remaining the same, the details of construction and forms of embodiment may be varied widely with respect to those described and illustrated, without thereby departing from the scope of the invention. For example, as an alternative to PEDOT-PSS it is possible to use as the hole-transport layer other materials that are conventionally used in organic devices, such as TPD (N,N'-diphenyl-N,N'-bis-(3-methylphenylen)-1,1'-diphenyl-4,4'-diamine) which can be deposited by evaporation or by spin-coating since it is soluble in toluene; PBD(2-(4-biphenyl)-5-(4-tert-butylphenyl)-1,3,4-oxadiazole) which can be deposited by evaporation; CuPc (copper phthalocyanine) which can be deposited by evaporation, or other phthalocyanines which can be deposited by spin-coating.

## Claims

1. An electroactive photonic device (D) comprising a substrate (1), at least one cathode layer (2), at least one anode layer (4), and at least one layer of active material (3) based on organic compounds and interposed at least partially between the anode and cathode layers (2, 4), the said layers (2, 3, 4) being arranged on the substrate (1) in a predetermined configuration such that the device (D) can convert luminous energy into electrical energy or *vice versa,* **characterized in that** the substrate (1) is made of float glass.

2. A device according to Claim 1 in which the substrate (1) is made of tempered glass.

3. A device according to any one of the preceding claims, in which the electrode layers (2) that are interposed between the substrate (1) and the layer of active material (3) are transparent to luminous radiation.

4. A device according to any one of the preceding claims in which the cathode and anode layers (4, 2) are transparent to luminous radiation.

5. A device according to Claim 4 or Claim 5 in which the transparent electrode layers (2, 4) are made of metal and are thin enough to allow light to be transmitted through them.

6. A device according to any one of the preceding claims in which the anode layers (2) are made of gold.

7. A device according to any one of the preceding claims in which the cathode layers (4) are made of aluminium.

8. A device according to any one of the preceding claims, further comprising a hole-transport layer interposed between the anode layers (2) and the layer (3) of active material.

9. A device according to Claim 8 in which the hole-transport layer is made of PEDOT-PSS, TPD, PBD, or CuPc.

10. A device according to any one of the preceding claims, further comprising an electron-transport layer interposed between the cathode layers (4) and the layer (3) of active material.

11. A device according to Claim 10 in which the electron-transport layer is made of aluminium tris-8-hydroxyquinoline.

12. A device according to any one of the preceding claims, **characterized in that** it is at least partially covered by an encapsulation layer.

13. A device according to any one of the preceding claims, configured as a light-emitting device.

14. A device according to any one of Claims 1 to 11, configured as a solar cell.

15. A light-emitting system, in particular, for illumination or indication, **characterized in that** it comprises a plurality of devices according to Claim 13, arranged in a predetermined configuration.
